# EUROPEAN PATENT SPECIFICATION

(11) **EP 0 939 407 B1**
(45) Date of publication and mention of the grant of the patent: **18.10.2006**
(21) Application number: 99301415.8
(22) Date of filing: 25.02.1999
(51) Int. Cl.: G11C 11/412, G11C 7/00

(54) **Compact, low voltage, noise-immune memory cell**
Kompakte, niederspannungs- und störungsunempfindliche Speicherzelle
Cellule de mémoire compacte, à basse tension et immune contre le bruit

(30) Priority: 26.02.1998 US 76009 P; 29.06.1998 US 106796; 05.02.1999 US 245428
(43) Date of publication of application: 01.09.1999
(73) Proprietor: ALTERA CORPORATION, San Jose, California 95134 (US)
(72) Inventor: Turner, John, Santa Cruz California 95060 (US); Mejia, Manuel, San Jose California 95116 (US)
(74) Representative: Smith, Samuel Leonard

(56) References cited:
- US-A- 4 879 687
- US-A- 5 280 201
- US-A- 5 325 325
- US-A- 5 479 369
- US-A- 5 764 564
- US-A- 5 870 331

## Description

### Field of the Invention

This invention relates generally to memory cells. More particularly, this invention relates to a memory cell for use in programmable logic devices and other electronic components.

### Background of the Invention

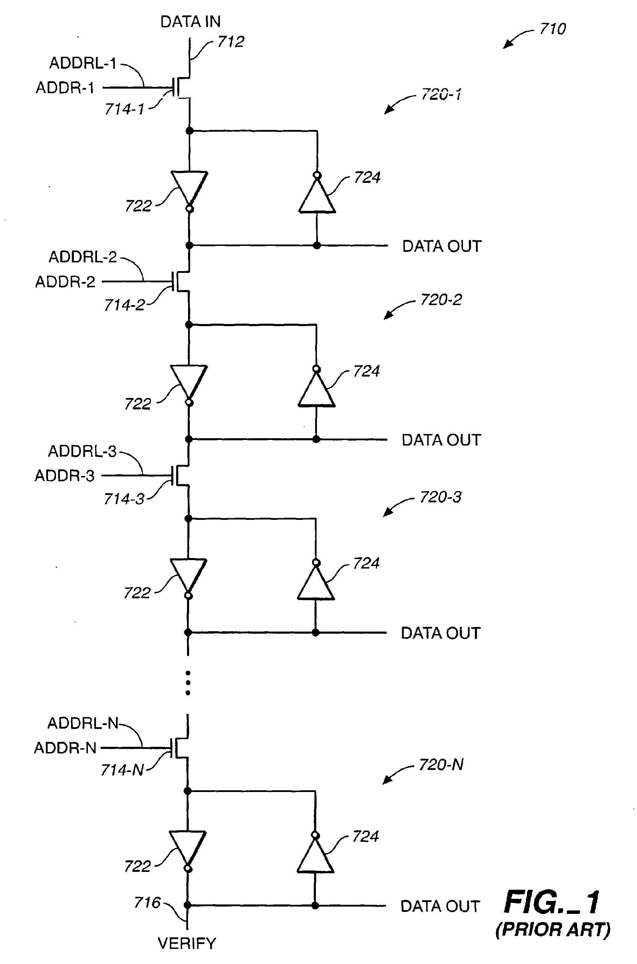

**Figure 1** is a simplified schematic diagram of a conventional first-in-first-out (FIFO) static random access memory (SRAM) chain. FIFO SRAM chains are well known in the art and are used in, among other things, programmable logic devices (PLDs), which are also well known in the art. In the FIFO SRAM chain (710) shown in **Figure 1**, each SRAM cell (720) includes a relatively strong, forwardly directed driver inverter (722) connected in a closed loop series with a relatively weak, backwardly directed feedback inverter (724). In the absence of a signal passed from above by an NMOS pass gate (714), each feedback inverter (724) is strong enough to hold the associated driver inverter (722), which may also be referred to as a forward inverter, in whatever state it was left by the most recent signal passed by the pass gate (714) immediately above. On the other hand, each feedback inverter (724) is not strong enough to prevent the associated driver inverter (722) from responding to any signal passed by the pass gate (714) immediately above. For each cell, driver inverter (722) and feedback inverter (724) collectively operate to store a single binary digit (bit).

Programming data is applied to FIFO chain (710) via DATA IN line (712) at the start of the chain. Initially all of pass gates (714) are enabled by address signals ADDR-1 through ADDR-N transmitted on address lines ADDRL-1 through ADDRL-N, respectively. This allows the first programming data bit to pass all the way down the chain (inverted by each successive driver inverter (722) that it passes through) until it reaches and is stored in cell (720-N).

Pass gate (714-N) is then turned off by changing the ADDR-N signal to logic 0. The next programming data bit from line (712) therefore passes down the chain until it reaches and is stored in the cell (720-(N-1)) immediately above cell (720-N) (not shown but similar to all other cells (720)). The NMOS pass gate (714) above the cell (720-(N-1)) is then turned off and the next programming data bit is applied to the DATA IN line (712). This process continues until all of cells (720) have been programmed and all of pass gates (714) have been turned off. Each cell (720) outputs the data it stores via its DATA OUT line. These DATA OUT signals may be used to control various aspects of the operation of a PLD that includes chain (710).

The contents of chain (710) may be verified by using the ADDR signals to enable pass gates (714) progressively from the bottom up. This allows the data in cells (720) to be read out one after another from the bottom up via VERIFY lead (716).

It will be apparent from the foregoing that in order to program or verify chain (710) each NMOS pass gate (714) must be able to effectively pass both logic 0 and logic 1 signals. When circuit components are made very small (as is becoming possible as a result of ongoing advances in the techniques for semiconductor fabrication) and VCC (the power voltage used for logic 1 signals) is accordingly reduced, an NMOS pass gate (714) may not be able to pass a logic 1 signal that is sufficiently strong to overwrite the logic 0 output of the feedback inverter (724) below it unless the pass gate is made undesirably large. Thus PMOS pass gate does not pass logic 0 very well under the above-described conditions that reduce the effectiveness of an NMOS pass gate in passing logic 1. FIFO SRAM chains are therefore becoming less satisfactory for use as the programmable elements in products such as PLDs.

Other drawbacks of the prior art FIFO SRAM cell are that (1) it requires a relatively large supply voltage, (2) it requires a relatively large amount of die area (because the feedback inverters (724) are weak devices with relatively large channel lengths and the access transistors (714) are relatively conductive devices with relatively large widths), and (3) it is susceptible to noise, such as noise glitches on the address lines.

In view of the foregoing, it would be highly desirable to develop a random access memory (RAM) cell that is noise-immune, compact, and does not require a large supply voltage.

Accordingly, it is desired that the present invention overcome the limitations of current FIFO cells and related programmable logic devices.

US 5,479,369 describes a semiconductor integrated circuit device having a data latch function. One of two inverters constituting a data launch circuit is formed of a PMOS transistor and a NMOS transistor, with the source terminal of the NMOS transistor being connected to the terminal for applying a reset signal. The reset signal is applied to an inverter through the NMOS transistor, and the inverter inverts the reset signal and resets the data latch circuit. Since one inverter of the data latch circuit is formed of the PMOS transistor and the NMOS transistor, the setting/resetting function of the semiconductor integrated circuit device can readily be implemented.

US 5,280,201 describes a semiconductor logic circuit apparatus which includes a first switching element consisting of a field effect transistor for changing holding data, an inverter circuit whose input is connected with one end of the first switching element, a feedback circuit whose input and output are connected with the output and input of the inverter circuit, and second switching element connected between the output of the feedback circuit and first or second potential. The second switching element is effective for enabling and disabling the feedback circuit.

US 5,764,564 describes a memory cell comprising a latch with cross-coupled inverters and an n-channel access transistor. The inverter that can contend with the access transistor is connected not between power and ground but between power and a transistor that disconnects the inverter from ground when the memory cell is being written. This allows transistors in the memory cell to be small and still function properly without requiring that a port be provided for the complement of the data signal. This is important when there are several write ports to the memory cell and the addressing overhead is significant.

US 5,325,325, an which the preamble of claim 1 is based, describes an SRAM having an array of memory cells each comprising first and second inverters provided in anti-parallel. The input and output of each memory cell is connected to bit lines by means of transistors which are turned on and off in response to a signal on a word line. Hence, in use, word lines are used to select memory cells by connecting them to bit lines and, when memory cells are connected to their respective bit lines, the bit lines provide storage data to those memory cells. This document additionally proposes the use of a master reset line which controls additional transistors connecting one or both of the inputs and outputs of the memory cells to one or both of a predetermined low potential and a predetermined high potential. In use, the SRAM can be initialised by using the word lines to disconnect all memory cells from the bit lines and then using the master reset line to connect the memory cells to the predetermined potentials.

According to the present invention, there is provided a memory cell comprising
a latch having an input for receiving a data signal, and further having an output;
a passing gate for coupling the data signal to the latch input in response to a control signal; and
a switch for selectively coupling the output of the latch to a predetermined potential in response to the data signal and the control signal in order to control the output of said latch.

In one embodiment of the present invention the switch includes a data select line pull down transistor having its gate connected to the data-in line of the memory cell and a row select line pull down transistor having its gate connected to the row select line. The data-in line pull down transistor and the row select line pull down transistor are coupled together such that when both transistors are turned on the output of the latch cell is pulled down by connection to a predetermined voltage low.

In another embodiment of the present invention the switch includes a row select line pull down transistor and a pull down inverter. The gate of the row select line pull down transistor is connected to the row select line. The source of the row select line pull down transistor is connected to the output of the latch cell. The drain of the row select line pull down transistor is connected to the output of the pull down inverter. The input of the pull down inverter is connected to the data-in line. The output of the latch cell is connected to the predetermined output of the pull down inverter when row select line pull down transistor is turned on in response to the control signal received on the row select line.

In another embodiment of the present invention the switch includes a data select line pull up transistor having its gate connected to the data-in line of the memory cell and a row select line pull up transistor having its gate connected to the row select line. The data-in line pull up transistor and the row select line pull up transistor are coupled together such that when both transistors are turned on the output of the latch cell is pulled high by connection to a predetermined voltage high.

In an another embodiment of the present invention the switch includes a row select line pull up transistor and a pull up inverter. The gate of the row select line pull up transistor is connected to the row select line. The source of the row select line pull up transistor is connected to the output of the latch cell. The drain of the row select line pull up transistor is connected to the output of the pull up inverter. The input of the pull up inverter is connected to the data-in line. The output of the latch cell is connected to the predetermined output of the pull up inverter when the row select line pull up transistor is turned on in response to the control signal received on the row select line.

In an alternate embodiment of the present invention a random access memory cell includes a data line, an address line, and a global clear line. An access transistor has an access transistor input node, an access transistor output node, and an access transistor control gate. The access transistor input node is connected to the data line and the access transistor control gate is connected to the address line. The cell also includes a forward inverter with a forward inverter input node and a forward inverter output node, The forward inverter input node is connected to the access transistor output node. A feedback inverter includes a feedback inverter input node, a feedback inverter output node, and a feedback inverter control node. The feedback inverter input node is connected to the forward inverter output node, the feedback inverter output node is connected to the access transistor output node, and the feedback inverter control node is connected to the global clear line. The feedback inverter includes a ground access transistor for selectively connecting and isolating the feedback inverter to ground, thereby controlling the output of the random access memory cell. This configuration allows for a compact, low voltage, noise-immune random access memory cell optimized for field programmable logic devices and other applications where write access times and programming times are not critical.

### Brief Description of the Drawings

For a better understanding of the invention, reference should be made to the following detailed description taken in conjunction with the accompanying drawings, in which:
**Figure 1** is a simplified schematic diagram of a conventional FIFO SRAM chain.
**Figure 2** is a schematic diagram of a FIFO cell having two pull down transistors, in accordance with the present invention.
**Figure 3** is a schematic diagram of a FIFO cell having a pull down transistor and a pull down inverter, in accordance with the present invention.
**Figure 4** is a schematic diagram of a FIFO cell having two pull up transistors, in accordance with the present invention.
**Figure 5** is a schematic diagram of a FIFO cell having a pull up transistor and a pull up inverter, in accordance with the present invention.
**Figure 6** illustrates a set of RAM cells constructed in accordance with an embodiment of the invention.
**Figure 7** illustrates the operation of a RAM cell of **Figure 6** during a global clear operation.
**Figure 8** illustrates the operation of a RAM cell of **Figure 6** when programming a logical one value.
**Figure 9** illustrates the operation of a RAM cell of **Figure 6** when programming a logical zero value.
**Figure 10** illustrates an alternate embodiment of a feedback inverter that may be used in accordance with the invention.
**Figure 11** illustrates a field programmable logic device incorporating the RAM cell of the invention, the field programmable logic device forming a portion of a data processing system.

Like reference numerals refer to corresponding parts throughout the drawings.

### Detailed Description of the Invention

One embodiment of the present invention provides a FIFO cell used in a programmable logic device. In the following description, numerous details are set forth in order to enable a thorough understanding of the present invention. However, it will be understood by those of ordinary skill in the art that these specific details are not required in order to practice the invention. Further, well-known elements, devices, process steps and the like are not set form in detail in order to avoid obscuring the present invention.

In the following figures like objects are given the same numbers in an effort to aid the reader in understanding the features of the present invention.

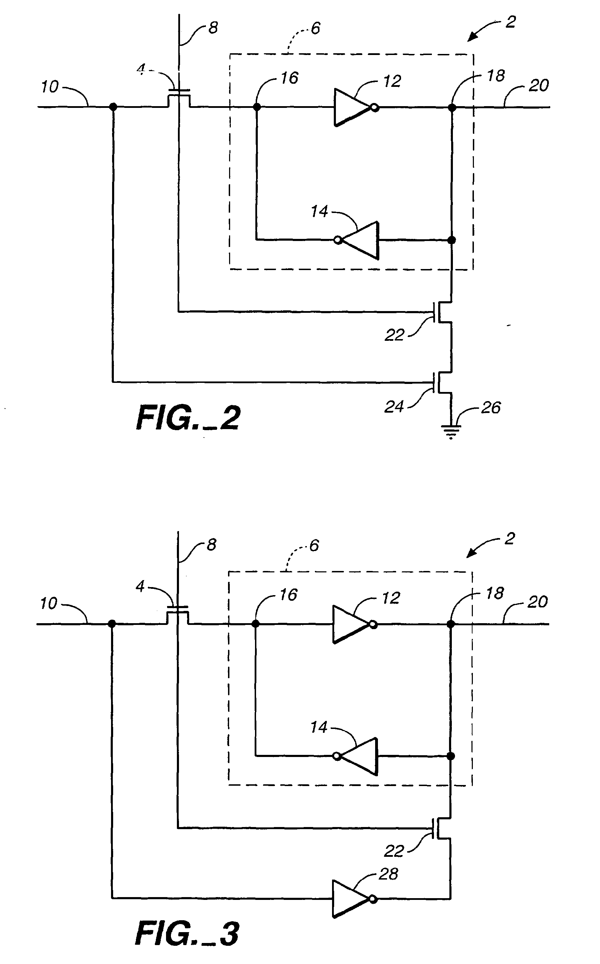

**Figure 2** is a schematic diagram of a FIFO cell (2) having a row select pull down transistor (22) and a line-in pull down transistor (24), in accordance with the present invention The FIFO cell (2) has a single pass gate transistor (4) and a latch cell (6). Typically, the pass gate transistor (4) is an NMOS transistor. The gate of the pass gate transistor (4) is connected to a row select line (8). The source of the pass gate transistor (4) is connected to a data-in line (10). The drain of the pass gate transistor (4) is connected to an input of the latch cell (6). When the pass gate transistor (4) is turned on, i.e. when the gate of the NMOS transistor is raised high to allow the transistor to pass signals through the transistor, then the data-in line (10) is electrically connected to the input of the latch cell (6). In this manner, the row select line (8) is used to "turn on" the pass gate transistor (4) to allow a digital "1" or a digital "0" to be written into the latch cell (6).

The latch cell (6) consists of a driver inverter (12) and a feedback inverter (14) cross coupled such that the output of one inverter is connected to the input of the other inverter. The latch cell (6) has an input node (16), which connects to the input of the driver inverter (12) and to the output of the feedback inverter (14). An output node (18) connects to the output of the driver inverter (12) and to the input of the feedback inverter (14). The inverters are standard CMOS inverters, where each typically consists of an NMOS transistor and a PMOS transistor.

The source of the row select pull down transistor (22) is connected to the output node (18). The gate of the row select pull down transistor (22) is connected to the row select line (8). The drain of the row select pull down transistor (22) is connected to the source of the data-in line pull down transistor (24). The gate of the data-in line pull down transistor (24) is connected to the data-in line (10). The drain of the data-in line pull down transistor (24) is connected to a voltage low (26), typically electrical ground. In this manner, the row select pull down transistor (22) and the data-in line pull down transistor (24) act as a switch to connect the output node (18) of the latch ceii to the voltage low (26).

While the above embodiment connected the output node of the latch cell to ground, other embodiments could connect to a voltage source which provides a predetermined voltage low.

Typically, a FIFO cell as shown in **Figure 2** is connected in a chain of like cells such that the data-out line of one cell is connected to the data-in line of a neighboring cell, The progression of data through the chain is controlled by a control signal applied on the row select line for each cell.

When a digital "1" (or logic "1") is written to the FIFO cell (2) shown in **Figure 2**, a voltage high, representing a digital "1," is input to the cell on the data-in line (10). The pass gate transistor (4) is turned on to allow writing to the cell by applying the control signal, represented by a voltage high, on the row select line (8) to the gate of the NMOS pass gate transistor (4). The turning on of the pass gate transistor (4) raises the voltage of the input node (16) of the latch cell (6). This voltage high is input to the driver inverter (12). The output from the driver inverter (12) is then a voltage low, which is input to the feedback inverter (14) and which pulls down the output node (18).

The voltage high on the data-in line (10) turns on the data-in line pull down transistor (24). The voltage high of the control signal on the row select line (8) turns on the row select line pull down transistor (22). When both the row select line pull down transistor (22) and the data-in line pull down transistor (24) are turned on, the output node (18) is electrically connected to ground (26). In this manner, the voltage of the output node (18) is pulled down by connecting the output node (18) to a voltage low, such as electrical ground (26), and by the voltage low output of the driver inverter (12) When the output node (18) is pulled down, a voltage low is input to the feedback inverter (14). Accordingly, the output of the feedback inverter (14) is a voltage high, which raises the input node (16). Thus, the feedback inverter maintains the voltage high at the input node (16). In this manner, a digital "1" is written to the latch cell (6).

Similarly, a digital "0" (or logic "0") is written to the FIFO cell (2) shown in **Figure 2** by providing a voltage low on the data-in line (10). A control signal in the form of a voltage high on the row select line (8) turns on the NMOS pass gate transistor (4) and allows the voltage low to pass through the pass gate transistor (4) to the input node (16) of the latch cell (6). The voltage low at the input node (16) is input the driver inverter (12). The driver inverter (12) outputs a voltage high to the output node (18) and to the feedback inverter (14). The feedback inverter (14) outputs a voltage low to the input node (16). Thus, the feedback inverter maintains the voltage low at the input node (16). The voltage low on the data-in line (10) keeps the data-in line pull down transistor (24) closed when writing a digital "0" to the latch cell (6). When the data-in line pull down transistor (24) is closed, the output node (18) of the latch cell (6) is electrically insulated from ground (26). This allows the output node (18) of the latch cell (6) to be high when writing a digital "0" to the latch cell.

If a digital "0" was previously written to the latch cell (6), the writing of a digital "1" to the cell must overcome the voltage low at the input node (16). This voltage low is sustained by the feedback inverter (14). To "flip" the cell the output node (18) is pulled down by turning on both the row select line pull down transistor (22) and the data-in line pull down transistor (24), thereby connecting the output node (18) to ground (26). Once the output node (18) is pulled down, the output of the feedback inverter (14) is a voltage high. The voltage high output from the feedback inverter (14), along with the voltage high from the data-in line (10), raises the input node (16). Once the input node (16) has been raised, the latch cell (6) has been "flipped" and a digital "1" has been written into the FIFO cell (2). In this manner, a "1" has been latched into the latch cell (6).

The FIFO cell (2) shown in **Figure 2** has several advantages over the prior art FIFO cells discussed above. As the cell is flipped when writing a digital "1" by pulling down the output node of the latch cell by connecting the latch cell to ground, the driver inverter need not overpower the feedback inverter to successfully flip the cell. This has the advantage of allowing short channel CMOS transistors to be used for the feedback inverter (14). Accordingly, this allows the area of the feedback inverter to be reduced.

Another advantage of the present FIFO cell is that the pass gate transistor can be constructed with a higher impedance since the latch cell can be flipped with a reduced current through the pass gate transistor as compared to conventional FIFO cells This allows a smaller NMOS transistor to be used for the pass gate transistor.

By using short channel CMOS transistors in the feedback inverter and a smaller NMOS transistor for the pass gate transistor, the total area of the cell can be reduced despite the inclusion of the two additional pull down transistors. Additionally, the present design allows for efficient and reliable operation of the cell in writing both a digital "1" and a digital "0" to the cell.

**Figure 3** is a schematic diagram of a FIFO cell having a row select line pull down transistor (22) and a pull down inverter (28), in accordance with the present invention. The gate of the row select line pull down transistor (22) is connected to the row select line (8). The source of the row select line pull down transistor (22) is connected to the output node (18) of the latch cell (6). The drain of the row select line pull down transistor (22) is connected to the output of the pull down inverter (28). The input of the pull down inverter (28) is connected to the data-in line (10). The pull down inverter is a standard inverter and is formed from an NMOS and a PMOS transistor. The configuration of the latch cell (6) with the driver inverter (12), feedback inverter (14), input node (16) and output node (18) is as described above with respect to **Figure 2**. Similarly, the connections of the source, drain and gate of the pass gate transistor (4) are as described above with respect to **Figure 2**.

In writing a digital "1" to the FIFO cell (2) shown in **Figure 3**, a voltage high is provided on the data in line (10). The pass gate transistor (4) is turned on by providing a control signal, represented by a voltage high, on the row select line (8) to the gate of the NMOS pass gate transistor (4). The voltage high from the data-in line (10) passes through the on pass gate transistor (4) and raises the input node (16) of the latch cell (6). This voltage high of the input node (16) is input to the driver inverter (12). The driver inverter (12) outputs a voltage low to the output node (18) and to the feedback inverter (14). The feedback inverter (14) outputs a voltage high to the input node (16). In this manner, the feedback inverter (14) maintains the voltage high of the input node (16). The voltage high of the data-in line (10) is input the pull down inverter (28), which outputs a voltage low. The voltage high of the control signal from the row select line (8) is input to the gate of the row select line pull down transistor (22). This turns on the row select line pull down transistor (22) and connects the output node (18) of the latch cell (6) to the output of the pull down inverter (28). As the output of the pull down inverter (28) is a voltage low, the turning on of the row select line pull down inverter acts to pull down the voltage of the output node (18) of the latch cell (6).

In writing a digital "0" to the FIFO cell (2) shown in **Figure 3**, a voltage low is provided on the data in line (10). The pass gate transistor (4) is turned on by providing a control signal, represented by a voltage high, on the row select line (8) to the gate of the NMOS pass gate transistor. The voltage low from the data-in line (10) passes through the on pass gate transistor (4) and lowers the input node (16) of the latch cell (6). This voltage low of the input node (16) is input to the driver inverter (12). The driver inverter (12) outputs a voltage high to the output node (18) and to the feedback inverter (14). The feedback inverter (14) outputs a voltage low to the input node (16). In this manner, the feedback inverter (14) maintains the voltage low of the input node (16). The voltage low of the data-in line (10) is input the pull down inverter (28), which outputs a voltage high. The voltage high from the row select line (8) is input to the gate of the row select line pull down transistor (22). This turns on the row select line pull down transistor (22) and connects the output node (18) of the latch cell (6) to the output of the pull down inverter (28). As the output of the pull down inverter (28) is a voltage high, the turning on of the row select line pull down inverter acts to drive high the voltage of the output node (18) of the latch cell (6).

If a digital "0" was previously written to the latch cell (6) of the FIFO cell (2) of **Figure 3**, the writing of a digital "1" to the latch cell must overcome the voltage low at the input node (16) sustained by the feedback inverter (14). To "flip" the cell the row select pull down transistor (22) is turned on, thereby connecting the output node (18) to a voltage low output from the pull down inverter (28). The voltage low from the pull down inverter (28) lowers the output node (18). This voltage low of the output node is input to the feedback inverter (14). The feedback inverter (14) outputs a voltage high to the input node (16) which, along with the voltage high from the data-in line (10), raises the input node (16). This "flips" the latch cell such that a digital "1" has been written into the cell.

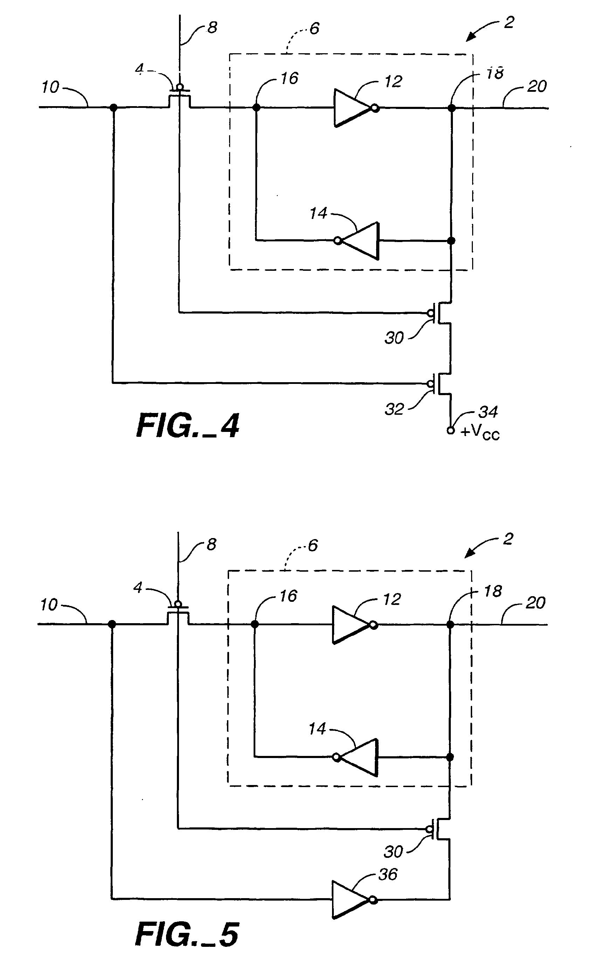

**Figure 4** is a schematic diagram of a FIFO cell (2) having two pull up transistors, in accordance with the present invention. The FIFO cell (2) is similar to the FIFO cell of **Figure 2** and differs by having the pass gate transistor (4) constructed from a PMOS transistor. The FIFO cell (2) also differs from the FIFO cell of **Figure 2** by having a row select line pull up transistor (30) and a data-in line pull up transistor (32) connecting the output node (18) of the latch cell (6) to a voltage source (34). Unlike the FIFO cell of **Figure 2**, the row select line pull up transistor (30) and the data-in line pull up transistor (32) are both formed from PMOS transistors. The voltage source (34) provides a predetermined voltage high, such as V_{CC}. The gate of the data-in line pull up transistor (32) is connected to the data-in line (10). The source of the data-in line pull up transistor (32) is connected to the voltage source (34). The drain of the data-in line pull up transistor (32) is connected to the source of the row select line pull up transistor (30). The gate of the row select line pull up transistor (30) connects to the row select line (8). The drain of the row select line pull up transistor (30) connects to the output node (18) of the latch cell (6) of the FIFO cell (2). In this manner, the row select pull up transistor (30) and the data-in line pull up transistor (32) act as a switch to connect the output node (18) of the latch cell to the voltage high (34). The driver inverter (12) and the feedback inverter (14) are both standard CMOS inverters which consist of a NMOS transistor and a PMOS transistor.

Writing a digital "1" into the FIFO cell (2) is accomplished by a voltage high, representing a digital "1," is input to the cell on the data-in line (10). The PMOS pass gate transistor (4) is turned on to allow writing to the cell by applying a control signal, represented by a voltage low, to the gate of the PMOS pass gate transistor (4) from the row select line (8). The turning on of the pass gate transistor (4) raises the voltage of the input node (16) of the latch cell (6). This voltage high input the input node (16) is input the driver inverter (12). The output from the driver inverter (12) is then a voltage low, which is input to the feedback inverter (14) and which pulls down the output node (18). The feedback inverter (14) outputs a voltage high which raises the input node (16). In this manner, the digital "1" is maintained by feedback inverter (14). The voltage low on the row select line (8) is input to the gate of the row select line pull up transistor (8). The voltage low of the control signal on the gate of the PMOS row select line pull up transistor (30) turns on the transistor and electrically connects the output node (18) of the latch cell (6) to the drain of the data-in line pull up transistor (32). The voltage high of the data-in line (10) is input to the gate of the data-in line pull up transistor (32). A voltage high on the gate of the PMOS data-in line pull up transistor (32) closes the transistor, thereby electrically isolating the latch cell (6) from the voltage source (34). In this manner, a digital "1" is written to the latch cell (6).

In contrast to the FIFO cell (2) shown in **Figure 2**, the difficulty in "flipping" the latch cell (6) occurs when a digital "0" is to be written into the latch cell that already has a digital "1" written into it, This difficulty occurs due to the inability of the pass gate transistor (4) to pass sufficient current to overcome the voltage low of the input node (16) maintained by the feedback inverter (14). To overcome this difficulty, the row select line pull up transistor (30) and the data-in line pull up transistor (32) are used to pull the output node (18) up by connecting the output node to a voltage high. The voltage high is represented by the voltage source (34). To write a digital "0" to the latch cell (6), a voltage low is input on the row select line (8) to turn on the PMOS pass gate transistor (4). A voltage low input to the pass gate transistor (4) from the data-in line (10) passes through the on pass gate transistor (4) to the input node (16) of the latch cell (6). The voltage low at the input node (16) is input to the driver inverter (12). The output of the driver inverter (12) is a voltage high, which is input to the output node (18) and to the feedback inverter (14). The feedback inverter (14) outputs a voltage low to the input node (16) and to the driver inverter (12). In this manner, the feedback inverter (12) maintains the voltage low if the input node (16). The voltage low on the row select line (8) is input to the gate of the row select line pull up transistor (8). As discussed above, the voltage low of the control signal on the gate of the PMOS row select line pull up transistor (30) turns on the transistor and electrically connects the output node (18) of the latch cell (6) to the drain of the data-in line pull up transistor (32). The voltage low of the data-in line (10) is input to the gate of the data-in line pull up transistor (32). A voltage low on the gate of the PMOS data-in line pull up transistor (32) turns on the transistor, thereby completing the connection between the output node (18) and the voltage source (34) The voltage high from the voltage source (34) pulls the output node (18) of the latch cell (6). The voltage high of the output node (18) is input to the feedback inverter (14). The feedback inverter (14) outputs a voltage low to the input node (16). The voltage low output from the feedback inverter (14), along with the voltage low from the data-in line (10), lowers the input node (16) and flips the latch cell (6). In this manner, a digital "0" is written to the latch cell (6).

**Figure 5** is a schematic diagram of a FIFO cell (2) having a pull up transistor and a pull up inverter, in accordance with the present invention. The FIFO cell (2) shown in **Figure 5** differs from the FIFO cell shown in **Figure 3** by using PMOS transistors for the pass gate transistor (4) and for a row select line pull up transistor (30). The gate of the row select line pull up transistor (30) connects to the row select line (8). The output node (18) of the latch cell (6) connects to the drain of the row select line pull up transistor (30). The source of the row select line pull up transistor (30) connects to the output of a pull up inverter (36). The input of the pull up inverter (36) connects to the data-in line (10).

In writing a digital "1" to the FIFO cell (2) shown in **Figure 5** a voltage high is provided on the data in line (10). The PMOS pass gate transistor (4) is turned on by providing a control signal, represented by voltage low, on the row select line (8) to the gate of the PMOS pass gate transistor (4). The voltage high from the data-in line (10) passes through the on pass gate transistor (4) and raises the input node (16) of the latch cell (6). This voltage high of the input node (16) is input to the driver inverter (12). The driver inverter (12) outputs a voltage low to the output node (18) and to the feedback inverter (14). The feedback inverter (14) outputs a voltage high to the input node (16). In this manner, the feedback inverter (14) maintains the voltage high of the input node (16). The voltage high of the data in line (10) is input to the pull up inverter (36), which outputs a voltage low. The voltage low of the control signal from the row select line (8) is input to the gate of the row select line pull up transistor (30). This turns on the PMOS row select line pull up transistor (30) and connects the output node (18) of the latch cell (6) to the output of the pull up inverter (36). As the output of the pull up inverter (36) is a voltage low, the turning on of the row select line pull up inverter acts to pull down the voltage of the output node (18) of the latch cell (6). In this manner, a digital "1" is written to the latch cell (6).

In writing a digital "0" to the FIFO cell (2) shown in **Figure 5** a voltage low is provided on the data in line (10). The PMOS pass gate transistor (4) is turned on by providing a voltage low on the row select line (8) to the gate of the pass gate transistor. The voltage low from the data-in line (10) passes through the on pass gate transistor (4) and lowers the input node (16) of the latch cell (6). This voltage low of the input node (16) is input to the driver inverter (12). The driver inverter (12) outputs a voltage high to the output node (18) and to the feedback inverter (14). The feedback inverter (14) outputs a voltage low to the input node (16). In this manner, the feedback inverter (14) maintains the voltage low of the input node (16). The voltage low of the data-in line (10) is input to the pull up inverter (28), which outputs a voltage high. The voltage low of the control signal from the row select line (8) is input to the gate of the row select line pull up transistor (30). This turns on the PMOS row select line pull up transistor (30) and connects the output node (18) of the latch cell (6) to the output of the pull up inverter (36). As the output of the pull up inverter (36) is a voltage high, the turning on of the row select line pull up inverter acts to raise the voltage of the output node (18) of the latch cell (6).

If a digital "0" was previously written to the latch cell (6) of the FIFO cell (2) of **Figure 5**, the writing of a digital "1" to the cell must overcome the voltage low at the input node (16) sustained by the feedback inverter (14). To "flip" the cell the row select pull down transistor (30) is turned on, thereby connecting the output node (18) to the voltage low output from the pull down inverter (36). The voltage low from the pull down inverter (36) pulls down the output node (18). The voltage low of the output node (18) is input to the feedback inverter (14). The feedback inverter (14) outputs a voltage high to the input node (16). The voltage high from the feedback inverter (14), along with the voltage high from the data-in line (10), raises the input node (16), thereby flipping the latch cell (6).

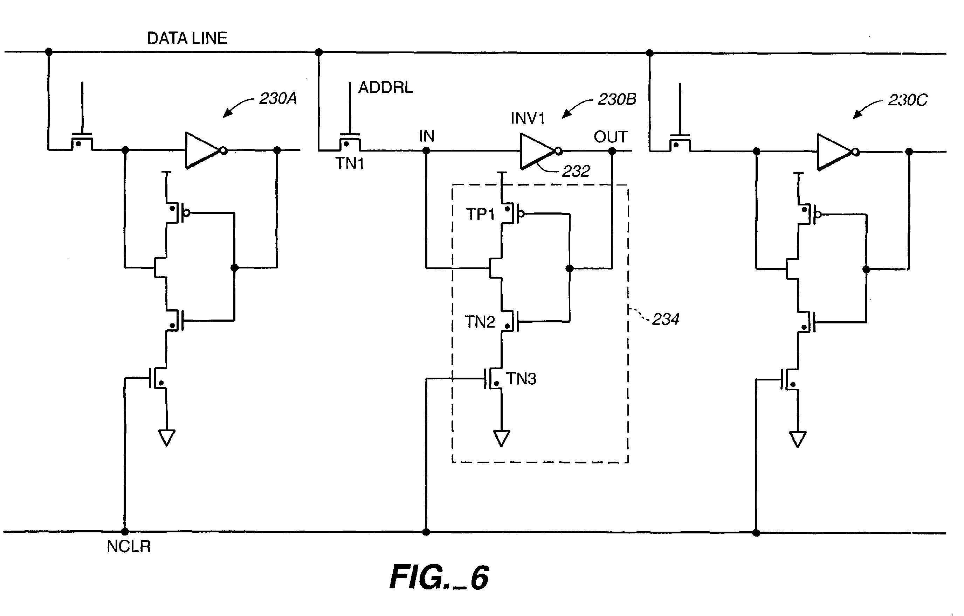

While the embodiments of the present invention shown in **Figures 2-5** have a connection to a predetermined voltage, through a switch, at the output node of the latch cell, alternate embodiments of the present invention, as shown in **Figures 6-10**, could use a switch connected to the feedback inverter of the latch cell to control the output of the latch cell by connecting the feedback inverter to a predetermined potential.

**Figure 6** illustrates three RAM cells 230A, 230B, and 230C constructed in accordance with an embodiment of the present invention. Each RAM cell 230 is connected between a data line and a global clear line (NCLR), as shown in the figure. Each RAM cell also includes a connection to an address line (ADDRL), which is connected to an access transistor TN1. The access transistor TN1 is connected to a standard forward inverter 232, which may also be referred to as a driver inverter, and a feedback inverter 234 comprising transistors TP1, TN2, and TN3. The feedback inverter 234 includes a ground access transistor TN3 which acts as a switch to selectively connect and isolate the feedback inverter 234 from ground, thereby controlling the output of the RAM cell, as discussed below.

It will be appreciated by those skilled in the art that the feedback inverter of each RAM cell 230 may be said to be coupled to ground access transistor TN3 rather than to include ground access transistor TN3. Thus , the present invention encompasses embodiments in which a feedback inverter does not include a ground access transistor, such as TN3, but is instead coupled to a ground access transistor, such as TN3, in a manner identical or equivalent to the coupling between TN2 and TN3.

The access transistor TN1 includes an input node connected to the data line, a control gate connected to the address line (ADDRL), and an output node connected to the input node (IN) of the forward inverter 232. The feedback inverter 234 includes an input node connected to the output node of the forward inverter 232. The feedback inverter 234 also includes an output node connected to the input node of the forward inverter 232.

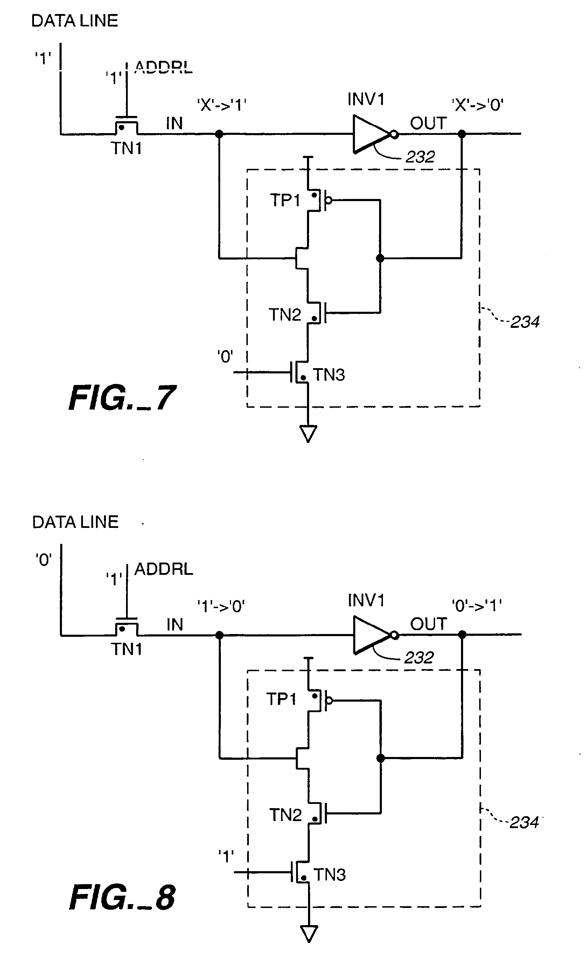

The RAM cell of the invention operates in a global clear mode and a programming mode. In the global clear mode, the outputs of all the RAM cells are driven low. This is done in the following manner. The global data line is driven to a digital high value, while the global clear line (NCLR) is driven low. The low signal on the global clear line (NCLR) causes transistor TN3 to turn-off, disconnecting the feedback inverter from ground. At the same time, the address lines (ADDRL) are driven with a digital high signal. The address line turns on transistor TN1, allowing the digital high signal on the data line to charge the input node to the forward inverter 232 to a digital high value. This causes the output of the forward inverter 232 to go low. This signal sequence is illustrated in **Figure 7**.

Observe that with this configuration, unlike the prior art, it is not necessary to have a high conductance access transistor TN1. In addition, a weak feedback inverter is not required. Thus, the relatively large access transistor with high conductance and weak feedback inverter of the prior art are unnecessary, allowing for a more compact RAM cell. The RAM cell of the invention can be implemented with devices of a minimum size. The limiting factor on operating voltage is the threshold voltage of TN1. The voltage supply must be greater than the voltage trip point and voltage threshold of TN1.

After the foregoing global clear operation is performed, the RAM cells may be programmed in the following manner. The global clear line (NCLR) is driven high, which turns-on the ground access transistor TN3, causing the ground access transistor TN3 to be connected to ground.

When a particular RAM cell needs to be written, its address line is driven high and the data line is driven to the complement of the value that needs to be stored in the RAM cell. For example, if a digital high value is to be stored, then the data line is driven low. The address line (ADDRL) is driven high, so transistor TN1 is turned-on and therefore applies the digital low value to the input node of inverter 232, as shown in Figure 8. TP 1 and TN1 are sized such that when both TP 1 and TN1 are activated, the voltage on the input node IN is below the trip point of inverter 232, which allows the output node to go high.

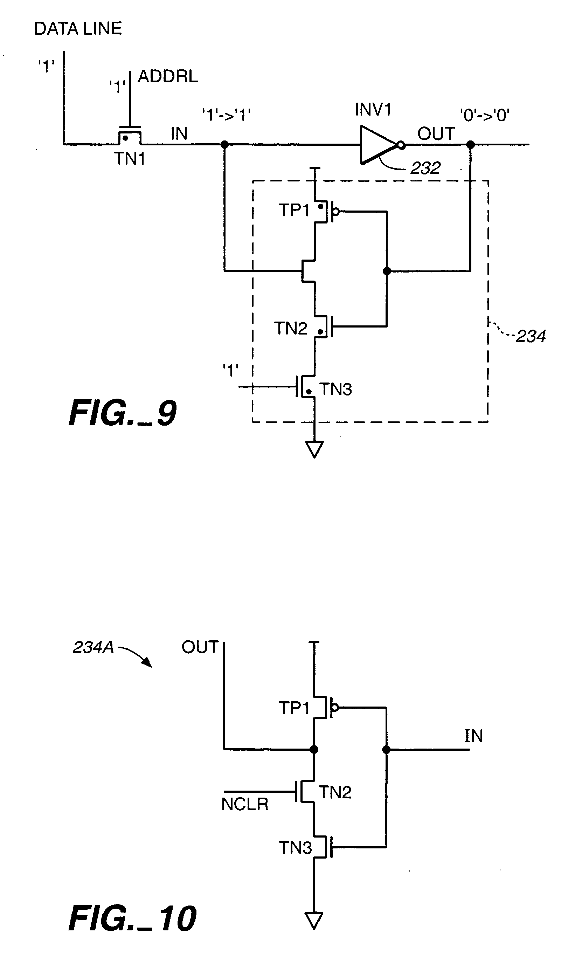

**Figure 9** illustrates the case of writing a digital low value to the RAM cell. This operation is identical to the global clear stage described in reference to **Figure 7**, with the exception that the transistor TN3 is on during the process. The fact that transistor TN3 is on during this operation is irrelevant since transistor TN2 is off.

After the RAM cells are programmed, the signals on the data line and NCLR line are driven high and the address lines are driven low. This configuration will provide noise immunity. For example, if there is a signal glitch on the data line, no data loss will occur because the access transistor TN1 isolates the RAM cell from the data line.

Similarly, no data loss will occur if there is a signal glitch on the NCLR line. Even though a signal glitch on the NCLR line will cause the feedback inverter to be temporarily disconnected from ground, charge will remain trapped on the input node IN because the transistor TN2 will remain off.

If the address line (ADDRL) glitches, there are two cases to consider. If the RAM cell output is zero, a signal glitch will continue to drive the zero output. That is, if the transistor TN1 turns-on because of a signal glitch, the digital high value from the data line will cause the inverter 232 to continue to produce a digital low value at its output. If the RAM cell output is one, a signal glitch on the address line will not disturb the output if the transistors TN1, TN2, and TN3 are sized such that the voltage at node IN is less than the trip point of the inverter 232. That is, TN1 TN2, and TN3 form a voltage divider. The respective devices are sized to create a voltage below the trip point of the inverter 232 when in a programmed state. In this event, the output of the inverter 232 is not disturbed.

**Figure 10** illustrates an alternate embodiment of a feedback inverter 234A that may be used in accordance with the invention. The feedback inverter 234A includes the same transistors, but the transistors are connected in a different configuration. The overall functionality of the feedback inverter 234A is the same as that of its previously discussed counterpart 234.

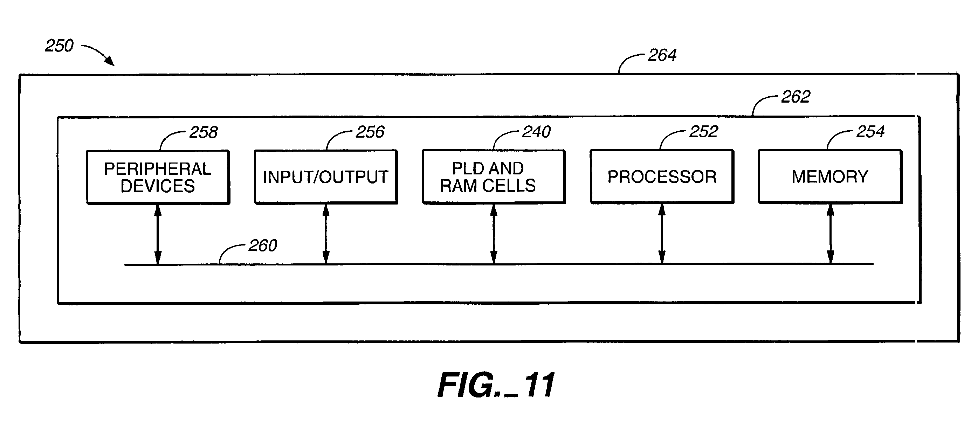

**Figure 11** illustrates a programmable logic device 240 incorporating the RAM cells 230 of the embodiment of the present invention described in **Figures 6-10**. More particularly, the figure illustrates the programmable logic device 240 embedded in a data processing system 250. The data processing system 250 may include one or more of the following components: a processor 252, memory 254, input/output circuitry 256, and peripheral devices 258. These components are coupled together by a system bus 260 and are populated on a circuit board 262, which is contained in an end-user system 264.

The system 250 can be used in a wide variety of applications, such as computer networking, data networking, instrumentation, video processing, digital signal processing, or any other application where the advantage of using reprogrammable logic and an EPROM is desirable. The device 240 can be used to perform a variety of logic functions. These functions may include using the device 240 as a processor or controller that works in cooperation with processor 252. The device 240 may also be used as an arbiter for arbitrating access to a shared resource in the system 250. In yet another example, the device 240 can be configured as an interface between the processor 252 and one of the other components in the system 250. It should be noted that the system 250 is only exemplary, and that the scope of the invention should be indicated by the claims.

All of the embodiments of the present invention allow for control of the value stored in the memory cell to be controlled by a switch which connects the memory cell, either at the output node or at the feedback inverter, to a predetermined potential, thereby allowing the size of the memory cell to be reduced as the feedback inverter of the cell need not be made relatively week.

The foregoing description, for purposes of explanation, used specific nomenclature to provide a thorough understanding of the invention However, it will be apparent to one skilled in the art that the specific details are not required in order to practice the invention. In other instances, well known circuits and devices are shown in block diagram form in order to avoid unnecessary distraction from the underlying invention. Thus, the foregoing descriptions of specific embodiments of the present invention are presented for purposes of illustration and description. They are not intended to be exhaustive or to limit the invention to the precise forms disclosed, obviously many modifications and variations are possible in view of the above teachings. The embodiments were chosen and described in order to best explain the principles of the invention and its practical applications, to thereby enable others skilled in the art to best utilize the invention and various embodiments with various modifications as are suited to the particular use contemplated. It is intended that the scope of the invention be defined by the following Claims and their equivalents.

## Claims

1. A memory cell (2) comprising:
a latch (6) having an input (16) for receiving a data signal, and further having an output (18);
a passing gate (4) for coupling the data signal to the latch input (16) in response to a control signal; and
a switch (30, 32) for selectively coupling the output (18) of the latch (6) to a predetermined potential (34) in response to the control signal in order to control the output (18) of said latch (6) **characterised in that** said selectively coupling is also in response to said data signal.

2. The memory cell (2) of claim 1, wherein the switch (30, 32) comprises:
a first switching transistor (30) responsive to the control signal; and
a second switching transistor (32) responsive to the data signal, wherein the second switching transistor (32) is coupled in series to the first switching transistor (30).

3. The memory cell (230A) of claim 1, wherein the memory cell (230A) is part of a plurality of memory cells (230A, 230B, 230C) in a FIFO chain.

4. The memory cell (2) of claim 1 further comprising:
a data-in line (10);
a row select line (8);
a data-out line (20);
an input node (16) of the latch (6); and
an output node (18) of the latch (6);
wherein the passing gate (4) comprises a pass gate transistor (4), wherein a gate of the pass gate transistor (4) is connected to the row select line (8) and wherein the pass gate transistor (4) is connected to the data-in line (10) and the input node (16) of the latch (6) such that when the pass gate transistor (4) is turned on the input node (10) of the latch (6) is electrically connected to the data-in line (10);
wherein the switch (22, 24) is connected between the output node (18) of the latch (6) and the predetermined potential (26) such that when the switch (22, 24) is turned on the output node (18) of the latch is electrically connected to the predetermined potential (26).

5. The memory cell (2) of claim 4, wherein the switch (22, 24) comprises:
a first switching transistor (22) having its gate connected to the row select line (8); and
a second switching transistor (24) having its gate connected to the data-in line (10),
wherein the first switching transistor (22) and the second switching transistor (24) are connected in series between the output node (18) of the latch (6) and the predetermined potential (26) such that the switch (22, 24) is turned on when the control signal is applied on the row select line (8) and the data signal is applied on the data-in line (10).

6. The memory cell (2) of claim 5, wherein the predetermined potential is a low voltage.

7. The memory cell (2) of claim 6, wherein the low voltage is electrical ground.

8. The memory cell (2) of claim 4, wherein the predetermined potential is a high voltage

9. The memory cell (230B) of claim 1, wherein said switch comprises a ground access transistor (TN3), further wherein said latch comprises a forward inverter (232) and a feedback inverter (234) connected to said forward inverter (232), said feedback inverter (234) including a ground access transistor (TN3) for selectively connecting and isolating said feedback inverter (234) to the predetermined potential, thereby controlling the output of said memory cell (230B).

10. The memory cell (230B) of claim 9 wherein the passing gate comprises an access transistor (TN1) with an access transistor input node connected to a data line, an access transistor gate connected to an address line, and an access transistor output node connected to said forward inverter and said feedback inverter.

11. The memory cell (230B) of claim 10 wherein said access transistor (TN1) and selected transistors of said feedback inverter (234) form a voltage divider when said memory cell(230B) is in a programmed state, such that an inadvertent logical high voltage on an input node of said forward inverter (232) is less then the trip voltage of said forward inverter (232).

12. The memory cell (230B) of claim 9, wherein the predetermined potential is electrical ground.

13. The memory cell (230B) of claim 9 further comprising:
a data line;
an address line; and
a global clear line;
wherein the passing gate comprises an access transistor (TN1) with an access transistor input node, an access transistor output node, and an access transistor control gate, said access transistor input node being connected to said data line and said access transistor control gate being connected to said address line;
wherein said forward inverter (232) comprises a forward inverter input node and a forward inverter output node, said forward inverter input node being connected to said access transistor output node;
further wherein said feedback inverter (234) comprises a feedback inverter input node, a feedback inverter output node, and a feedback inverter control node, said feedback inverter input node being connected to said forward inverter output node, said feedback inverter output node being connected to said access transistor output node, and said feedback inverter control node being connected to said global clear line.

## Patentansprüche

1. Speicherzelle (2) umfassend:
einen Latch (6) mit einem Eingang (16) zum Empfangen eines Datensignals und ferner mit einem Ausgang (18);
ein Durchgangsgatter (4) zum Koppeln des Datensignals mit dem Latcheingang (16) in Abhängigkeit von einem Steuersignal; und
einen Schalter (30, 32) zum selektiven Koppeln des Ausgangs (18) des Latchs (6) mit einem vorbestimmten Potenzial (34) in Abhängigkeit von dem Steuersignal, um den Ausgang (18) des Latchs (6) zu steuern,
**dadurch gekennzeichnet,**
**dass** das selektive Koppeln ferner in Abhängigkeit von dem Datensignal erfolgt.

2. Speicherzelle (2) nach Anspruch 1, wobei der Schalter (30, 32) umfasst:
einen ersten Schalttransistor (30), welcher auf das Steuersignal reagiert; und
einen zweiten Schalttransistor (32), welcher auf das Datensignal reagiert, wobei der zweite Schalttransistor (32) in Reihe mit dem ersten Schalttransistor (30) gekoppelt ist.

3. Speicherzelle (230A) nach Anspruch 1, wobei die Speicherzelle (230A) ein Teil mehrerer Speicherzellen (230A, 230B, 230C) in einer FIFO-Kette ist.

4. Speicherzelle (2) nach Anspruch 1, ferner umfassend:
eine Dateneingangsleitung (10);
eine Zeilenauswahlleitung (8);
eine Datenausgangsleitung (20);
einen Eingangsknoten (16) des Latchs (6); und
ein Ausgangsknoten (18) des Latchs (6);
wobei das Durchgangsgatter (4) einen Durchgangsgattertransistor (4) umfasst, wobei ein Gateanschluss des Durchgangsgattertransistors (4) mit der Zeilenauswahlleitung (8) verbunden ist und wobei der Durchgangsgattertransistor (4) mit der Dateneingangsleitung (10) und dem Eingangsknoten (16) des Latchs (6) derart verbunden ist, dass, wenn der Durchgangsgattertransistor (4) eingeschaltet ist, der Eingangsknoten (16) des Latchs (6) elektrisch mit der Dateneingangsleitung (10) verbunden ist;
wobei der Schalter (22, 24) zwischen dem Ausgangsknoten (18) des Latchs (6) und dem vorbestimmten Potenzial (26) derart verbunden ist, dass, wenn der Schalter (22, 24) eingeschaltet ist, der Ausgangsknoten (18) des Latchs elektrisch mit dem vorbestimmten Potenzial (26) verbunden ist.

5. Speicherzelle (2) nach Anspruch 4, wobei der Schalter (22, 24) umfasst:
einen ersten Schalttransistor (22) dessen Gateanschluss mit der Zeilenauswahlleitung (8) verbunden ist; und
einen zweiten Schalttransistor (24), dessen Gateanschluss mit der Dateneingangsleitung (10) verbunden ist,
wobei der erste Schalttransistor (22) und der zweite Schalttransistor (24) in Reihe zwischen dem Ausgangsknoten (18) des Latchs (6) und dem vorbestimmten Potenzial (26) derart verbunden sind, dass der Schalter (22, 24) eingeschaltet wird, wenn das Steuersignal an die Zeilenauswahlleitung (8) angelegt wird und das Datensignal an die Dateneingangsleitung (10) angelegt wird.

6. Speicherzelle (2) nach Anspruch 5, wobei das vorbestimmte Potenzial eine niedrige Spannung ist.

7. Speicherzelle (2) nach Anspruch 6, wobei die niedrige Spannung die elektrische Masse ist.

8. Speicherzelle (2) nach Anspruch 4, wobei das vorbestimmte Potenzial eine hohe Spannung ist.

9. Speicherzelle (230B) nach Anspruch 1, wobei der Schalter einen Massezugangstransistor (TN3) umfasst, wobei das Latch ferner einen Vorwärtsinverter (232) und einen Rückkopplungsinverter (234), welcher mit dem Vorwärtsinverter (232) verbunden ist, umfasst, wobei der Rückkopplungsinverter (234) einen Massezugangstransistor (TN3) zum selektiven Verbinden und Isolieren des Rückkopplungsinverters (234) mit dem bzw. von dem vorbestimmten Potenzial aufweist, wodurch die Ausgabe der Speicherzelle (230B) gesteuert wird.

10. Speicherzelle (230B) nach Anspruch 9, wobei das Durchgangsgatter einen Zugangstransistor (TN1) mit einem Zugangstransistoreingangsknoten, welcher mit einer Datenleitung verbunden ist, einen Zugangstransistorgateanschluss, welcher mit einer Adressleitung verbunden ist, und einen Zugangstransistorausgangsknoten, welcher mit dem Vorwärtsinverter und dem Rückkopplungsinverter verbunden ist, umfasst.

11. Speicherzelle (230B) nach Anspruch 10, wobei der Zugangstransistor (TN1) und ausgewählte Transistoren des Rückkopplungsinverters (234) einen Spannungsteiler ausbilden, wenn die Speicherzelle (230B) in einem programmierten Zustand ist, so dass eine versehentliche logisch hohe Spannung an dem Eingangsknoten des Vorwärtsinverters (232) geringer als die Auslösespannung des Vorwärtsinverters (232) ist.

12. Speicherzelle (230B) nach Anspruch 9, wobei das vorbestimmte Potenzial elektrische Masse ist.

13. Speicherzelle (230B) nach Anspruch 9, ferner umfassend:
eine Datenleitung;
eine Adressleitung; und
eine allgemeine Löschleitung;
wobei das Durchgangsgatter einen Zugangstransistor (TN1) mit einem Zugangstransistoreingangsknoten, einen Zugangstransistorausgangsknoten und einen zugangstransistorgateanschluss umfasst, wobei der Zugangstransistoreingangsknoten mit der Datenleitung verbunden ist und der Zugangstransistorgateanschluss mit der Adressleitung verbunden ist;
wobei der Vorwärtsinverter (232) einen Vorwärtsinvertereingangsknoten und einen Vorwärtsinverterausgangsknoten umfasst, wobei der Vorwärtsinvertereingangsknoten mit dem Zugangstransistorausgangsknoten verbunden ist;
wobei der Rückkopplungsinverter (234) ferner einen Rückkopplungsinvertereingangsknoten, einen Rückkopplungsinverterausgangsknoten und einen Rückkopplungsinvertersteuerknoten umfasst, wobei der Rückkopplungsinvertereingangsknoten mit dem Vorwärtsinverterausgangsknoten verbunden ist, der Rückkopplungsinverterausgangsknoten mit dem Zugangstransistorausgangsknoten verbunden ist und der Rückkopplungsinvertersteuerknoten mit der allgemeinen Löschleitung verbunden ist.

## Revendications

1. Cellule (2) de mémoire, comprenant :
un circuit à verrouillage (6) ayant une entrée (16) pour recevoir un signal de données et ayant en outre une sortie (18) ;
une porte de passage (4) pour coupler le signal de données à l'entrée (16) du circuit à verrouillage en réponse à un signal de commande ; et
un commutateur (30, 32) pour coupler de manière sélective la sortie (18) du circuit à verrouillage (6) à un potentiel prédéterminé en réponse au signal de commande afin de commander la sortie (18) dudit circuit à verrouillage (6), **caractérisée en ce que** ledit couplage sélectif a lieu également en réponse audit signal de données.

2. Cellule (2) de mémoire selon la revendication 1, dans laquelle le commutateur (30, 32) comprend :
un premier transistor de commutation (30) réagissant au signal de commande ; et
un second transistor de commutation (32) réagissant au signal de données, le second transistor de commutation (32) étant monté en série avec le premier transistor de commutation (30).

3. Cellule (230A) de mémoire selon la revendication 1, la cellule (230A) de mémoire faisant partie d'une pluralité de cellules (230A, 230B, 230C) de mémoire dans une chaîne PEPS.

4. Cellule (2) de mémoire selon la revendication 1, comprenant en outre :
une ligne (10) d'entrée de données ;
une ligne (8) de sélection de rangée ;
une ligne (20) de sortie de données ;
un noeud d'entrée (16) du circuit à verrouillage (6); et
un noeud de sortie (18) du circuit à verrouillage (6) ;
dans ladite cellule, la porte de passage (4) consistant en un transistor (4) à grille de passage,une grille du transistor (4) à grille de passage étant connectée à la ligne (8) de sélection de rangée, et le transistor (4) à grille de passage étant connecté à la ligne (10) d'entrée de données et au noeud d'entrée (16) du circuit à verrouillage (6) de telle sorte que, lorsque le transistor à grille de passage (4) devient passant, le noeud d'entrée (10) du circuit à verrouillage (6) est électriquement connecté à la ligne (10) d'entrée de données ;
dans ladite cellule, le commutateur (22, 24) étant monté entre le noeud de sortie (18) du circuit à verrouillage (6) et le potentiel prédéterminé (26) de façon que, lorsque le commutateur (22, 24) devient passant, le noeud de sortie (18) du circuit à verrouillage soit électriquement connecté au potentiel prédéterminé (26).

5. Cellule (2) de mémoire selon la revendication 4, dans laquelle le commutateur (22, 24) consiste en :
un premier transistor de commutation (22) dont la grille est connectée à la ligne (8) de sélection de rangée ; et
un second transistor de commutation (24) dont la grille est connectée à la ligne (10) d'entrée de données,
dans ladite cellule, le premier transistor de commutation (22) et le second transistor de commutation (24) étant montés en série entre le noeud de sortie (18) du circuit à verrouillage (6) et le potentiel prédéterminé (26) de façon que le commutateur (22, 24) devienne passant lorsque le signal de commande est appliqué à la ligne (8) de sélection de rangée et lorsque le signal de données est appliqué sur la ligne (10) d'entrée de données.

6. Cellule (2) de mémoire selon la revendication 5, dans laquelle le potentiel prédéterminé est une basse tension.

7. Cellule (2) de mémoire selon la revendication 6, dans laquelle la basse tension est une terre électrique.

8. Cellule (2) de mémoire selon la revendication 4, dans laquelle le potentiel prédéterminé est une haute tension.

9. Cellule (230B) de mémoire selon la revendication 1, dans laquelle ledit commutateur consiste en un transistor (TN3) d'accès à la terre, dans laquelle en outre ledit circuit à verrouillage comporte un onduleur direct (232) et un onduleur de retour (234) connecté audit onduleur direct (232), ledit onduleur de retour (234) comportant un transistor (TN3) d'accès à la terre pour connecter et isoler de manière sélective ledit onduleur de retour (234) à/par rapport au potentiel prédéterminé, en commandant de ce fait la sortie de ladite cellule (230B) de mémoire.

10. Cellule (230B) de mémoire selon la revendication 9, dans laquelle la porte de passage consiste en un transistor d'accès (TN1) avec un noeud d'entrée de transistor d'accès connecté à une ligne de données, une grille de transistor d'accès connectée à une ligne d'adresse et un noeud de sortie de transistor d'accès connecté audit onduleur direct et audit onduleur de retour.

11. Cellule (230B) de mémoire selon la revendication 10, dans laquelle ledit transistor d'accès (TN1) et certains transistors dudit onduleur de retour (234) forment un diviseur de tension lorsque ladite cellule (230B) de mémoire est dans un état programmé, de telle sorte qu'une haute tension logique accidentelle à un noeud d'entrée dudit onduleur direct (232) soit inférieure à la tension de déclenchement dudit onduleur direct (232).

12. Cellule (230B) de mémoire selon la revendication 9, dans laquelle le potentiel prédéterminé est une terre électrique.

13. Cellule (230B) de mémoire selon la revendication 9, comprenant en outre :
une ligne de données ;
une ligne d'adresse ; et
une ligne d'effacement global ;
dans laquelle la porte de passage consiste en un transistor d'accès (TN1) à noeud d'entrée de transistor d'accès, noeud de sortie de transistor d'accès et grille de commande de transistor d'accès, ledit noeud d'entrée de transistor d'accès étant connecté à la ligne de données et ladite grille de commande de transistor d'accès étant connectée à ladite ligne d'adresse ;
ledit onduleur direct (232) comportant un noeud d'entrée d'onduleur direct et un noeud de sortie d'onduleur direct, ledit noeud d'entrée d'onduleur direct étant connecté audit noeud de sortie de transistor d'accès;
en outre, ledit onduleur direct (234) comporte un noeud d'entrée d'onduleur de retour, un noeud de sortie d'onduleur de retour et un noeud de commande d'onduleur de retour, ledit noeud d'entrée d'onduleur de retour étant connecté audit noeud de sortie d'onduleur avant, ledit noeud de sortie d'onduleur de retour étant connecté audit noeud de sortie de transistor d'accès et ledit noeud de commande d'onduleur de retour étant connecté à ladite ligne d'effacement global.
